(19) Europäisches Patentamt
European Patent Office
Office européen des brevets

(11) EP 4 633 029 A1

(12) EUROPEAN PATENT APPLICATION

(43) Date of publication:
15.10.2025 Bulletin 2025/42

(51) International Patent Classification (IPC):
H02M 3/335 (2006.01)    G01R 19/00 (2006.01)

(21) Application number: 25168929.5

(52) Cooperative Patent Classification (CPC):
H02M 3/33507; G01R 19/0084; H02M 3/33523;
H02M 1/0006; H02M 1/0095

(22) Date of filing: 07.04.2025

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH LA MA MD TN

(30) Priority: 08.04.2024  IN 202411028638

(71) Applicant: Hamilton Sundstrand Corporation
Charlotte, NC 28217-4578 (US)

(72) Inventors:
• ESWARAN, Pravinsharma Kaliyannan
560066 Whitefield, Bangalore (IN)
• KALLURI, Nageswara Rao
560016 Nagar, Bangalore (IN)
• PERUMAL, Rajkumar
560049 Bangalore (IN)
• KATAKAM, Sridhar
560036 Krishna Raja Pura, Bangalore (IN)
• SEMBANAN, Anbarasu
560064 Bengaluru, Karnataka (IN)

(74) Representative: Dehns
10 Old Bailey
London EC4M 7NG (GB)

(54) **HIGH VOLTAGE DIRECT CURRENT BUS MONITORING FOR MOTOR DRIVE APPLICATIONS**

(57) A direct current (DC) voltage monitoring circuit includes a switch mode power supply (102), a transformer (105), and a rectifier circuit (120). The switch mode power supply (102) provides an input voltage. The transformer (105) includes a primary winding in signal communication with the switch mode power supply (102). The transformer (105) stores energy induced by a primary voltage applied across the transformer (105) by the input voltage (Vin) in response to the switch mode power supply (102) operating in the "ON" state, releases the energy as a secondary voltage to be used as an output voltage in response to the switch mode power supply (102) operating in the "OFF" state. The rectifier circuit (120) generates a monitored voltage indicative of the input voltage in response to the switch mode power supply (102) operating in the "ON" state, and rectifies the output voltage generated by the transformer (105) in response to the switch mode power supply (102) operating in the "OFF" state.

FIG. 1

EP 4 633 029 A1

**Description**

CROSS-REFERENCE TO RELATED APPLICATIONS

This application claims the benefit of India Patent Application No. 202411028638 filed April 8, 2024.

BACKGROUND

Exemplary embodiments of the present disclosure generally relate to aerospace electrical systems, and more particularly, to a high-voltage direct current electrical bus monitoring circuit for motor drive applications.

Aerospace motor drive systems are critical components that convert electrical energy into mechanical energy, powering various functions from propulsion to auxiliary systems in aircraft and spacecraft. These systems must be highly efficient, reliable, and compact, given the stringent weight and space constraints inherent in aerospace engineering. Improving the power density of these motor drives (e.g., essentially packing more power into a smaller, lighter package) is a key objective to enhance overall vehicle performance and fuel efficiency. Reducing copper losses, the energy lost as heat due to the resistance in the motor's copper windings, is a direct method to achieve this. By minimizing these losses, the motor drive can operate more efficiently, converting a greater portion of electrical energy into mechanical energy. This not only improves the system's performance but also contributes to the reduction of the aircraft's energy consumption and operational costs, making the quest for higher power density through reduced copper losses a critical endeavor in aerospace motor drive applications.

BRIEF DESCRIPTION

According to a non-limiting embodiment, a direct current (DC) voltage monitoring circuit includes a switch mode power supply, a transformer, and a rectifier circuit. The switch mode power supply provides an input voltage (Vin). The transformer includes a primary winding in signal communication with the switch mode power supply. The transformer stores energy induced by a primary voltage applied across the transformer by the input voltage (Vin) in response to the switch mode power supply operating in the "ON" state, releases the energy as a secondary voltage (Vsecondary) to be used as an output voltage (Vout) in response to the switch mode power supply operating in the "OFF" state. The rectifier circuit generates a monitored voltage (Vmon) indicative of the input voltage (Vin) in response to the switch mode power supply operating in the "ON" state, and rectifies the output voltage (Vout) generated by the transformer in response to the switch mode power supply operating in the "OFF" state.

In addition to one or more of the features described above, or as an alternative to any of the foregoing embodiments, the switch mode power supply includes a flyback converter.

In addition to one or more of the features described above, or as an alternative to any of the foregoing embodiments, the flyback converter comprises a first switch configured to continuously switch between an "ON" state and an "OFF" state at a switching frequency (Fsw).

In addition to one or more of the features described above, or as an alternative to any of the foregoing embodiments, the transformer comprises a primary winding configured to realize a primary voltage (Vprimary) based on the input voltage (Vin); and a secondary winding configured to deliver the secondary voltage (Vsecondary) to the rectifier circuit.

In addition to one or more of the features described above, or as an alternative to any of the foregoing embodiments, the flyback converter is configured to apply the input voltage (Vin) across the primary winding to induce the transformer to store energy when the first switch operates in the "ON" state and is configured to release the stored energy to apply the secondary voltage (Vsecondary) across the secondary winding when the first switch operates in the "OFF" state.

In addition to one or more of the features described above, or as an alternative to any of the foregoing embodiments, the rectifier circuit comprises a half rectifier configured to rectify the output voltage (Vout); and a voltage monitoring circuit configured to generate the monitored voltage (Vmon).

In addition to one or more of the features described above, or as an alternative to any of the foregoing embodiments, the half rectifier comprises a first diode including an anode in signal communication with a first end of the secondary winding and a cathode in signal communication with a voltage output; an output capacitor including a first terminal connected in common with the cathode of the first diode and the voltage output, and a second terminal connected to a ground reference point.

In addition to one or more of the features described above, or as an alternative to any of the foregoing embodiments, the voltage monitoring circuit comprises a second diode including an anode connected to the ground reference point and including a cathode connected in common with the first end of the secondary winding; a third diode including an anode connected in common with the anode of the second diode and the ground reference point, and including a cathode connected to the second end of the secondary transformer; a fourth diode including an anode connected in common with the second end of the secondary winding; a series resistor having a first end connected to a cathode of the fourth diode and having an opposing second end configured to deliver the monitored voltage to an analog-to-digital converter (ADC); and a sampling capacitor including a first terminal connected to the ground reference point and an opposing second terminal connected to the second terminal of the series resistor.

In addition to one or more of the features described above, or as an alternative to any of the foregoing embodiments, the a sampling circuit comprises a discharge switch configured to operate in a "discharge OFF" state that activates a sampling operation to sample the input voltage (Vin) and a "discharge ON" state that deactivates the sampling operation.

In addition to one or more of the features described above, or as an alternative to any of the foregoing embodiments, the sampling operation determines an accuracy of the input voltage (Vin).

In addition to one or more of the features described above, or as an alternative to any of the foregoing embodiments, the sampling operation comprises a data sampling phase configured to obtain a samples of the monitored voltage (Vmon); an analyzing phase configured to analyze the input voltage based on the samples of the monitored voltage (Vmon); a discharge cycle phase configured to reset the monitored voltage (Vmon); and a charging phase configured to charge the sampling capacitor.

According to another non-limiting embodiment, a method of monitoring direct current (DC) voltage is provided. The method comprises providing an input voltage (Vin) from a switch mode power supply; storing energy in a transformer including a primary winding in signal communication with the switch mode power supply, the storing of the energy induced by applying a primary voltage in response to the switch mode power supply operating in the "ON" state; and releasing the energy from the transformer as a secondary voltage (Vsecondary) to be used as an output voltage (Vout) in response to the switch mode power supply operating in the "OFF" state. The method further comprises generating a monitored voltage (Vmon) from a rectifier circuit configured to generate a monitored voltage (Vmon) indicative of the input voltage (Vin) in response to the switch mode power supply operating in the "ON" state; and rectifying the output voltage (Vout) using the rectifier circuit in response to the switch mode power supply operating in the "OFF" state.

BRIEF DESCRIPTION OF THE DRAWINGS

The following descriptions should not be considered limiting in any way. With reference to the accompanying drawings, like elements are numbered alike:

FIG. 1 illustrates a high-voltage DC bus monitoring circuit according to a non-limiting embodiment of the present disclosure;

FIG. 2 illustrates the high-voltage DC bus monitoring circuit operating in a first operating state according to a non-limiting embodiment of the present disclosure;

FIG. 3 illustrates the high-voltage DC bus monitoring circuit operating in a second operating state according to a non-limiting embodiment of the present disclosure;

FIG. 4 depicts waveform diagrams associated with operation of the high-voltage DC bus monitoring circuit according to a non-limiting embodiment of the present disclosure.

FIG. 5 is a flow diagram illustrating a method of performing continuous monitoring of a supply voltage provided by the switch mode power supply according to a non-limiting embodiment of the present disclosure.

DETAILED DESCRIPTION

A detailed description of one or more embodiments of the disclosed apparatus and method are presented herein by way of exemplification and not limitation with reference to the Figures.

Increasing the DC input or bus voltage emerges as a promising strategy to enhance the efficiency and performance of aerospace motor drive systems. This strategy directly addresses the need for higher power density in aerospace applications, where the premium on weight and space necessitates compact yet powerful motor drive systems. By elevating the input voltage, the system can achieve the same power output with lower current, thereby significantly reducing copper losses due to resistance in the motor windings and associated conductive paths. This reduction in losses not only improves the overall efficiency of the motor drive but also contributes to the miniaturization of the system, a critical factor in aerospace design where every gram and every cubic centimeter must be justified.

However, the approach of increasing the DC bus voltage introduces a set of technical challenges that must be carefully navigated. Primary among these is the issue of electrical isolation. High voltage systems require stringent isolation from low voltage circuitry to ensure both the safety and integrity of the motor drive. This isolation is crucial to prevent inadvertent current paths that could lead to premature component failure or, worse, pose a risk to the entire system. Moreover, the elevated voltages necessitate a meticulous selection of components capable of handling increased electrical stresses without compromising the system's reliability and longevity. Components must not only be selected for their ability to scale with the required voltage but also for their precision, efficiency, and minimal power loss, ensuring the system remains robust under the demanding conditions of aerospace operation.

Compounding these challenges is the overarching requirement for reliability in aerospace applications. The motor drive system must exhibit an unwavering performance over a wide range of operational conditions, with minimal risk of failure. This necessitates a design philosophy that prioritizes the durability and resilience of every component within the system. The high voltage environment exacerbates the selection process, demanding components that not only meet the immediate electrical requirements but also withstand the rigors of aerospace operation over time. Achieving this level of reliability while managing the increased complexity and potential safety concerns of high voltage systems underscores the intricate balance that must be struck in the design and implementation of advanced aerospace motor drives.

Various non-limiting embodiments address the challenges of described above by providing a high-voltage direct current (DC) bus monitoring circuit, which can be utilizes in various motor drive applications. According to a non-limiting embodiment, the high-voltage DC bus monitoring circuit performs a flyback operation while also generating a sense voltage that can be used to monitor the DC bus. Accordingly, a high-voltage direct current (DC) bus monitoring circuit can implement an isolated transformer and very few components to provide low voltage conditioning before an analog-to-digital converter (ADC) digitizes the signal to analyzed using on-board intelligence (FPGA/DSP).

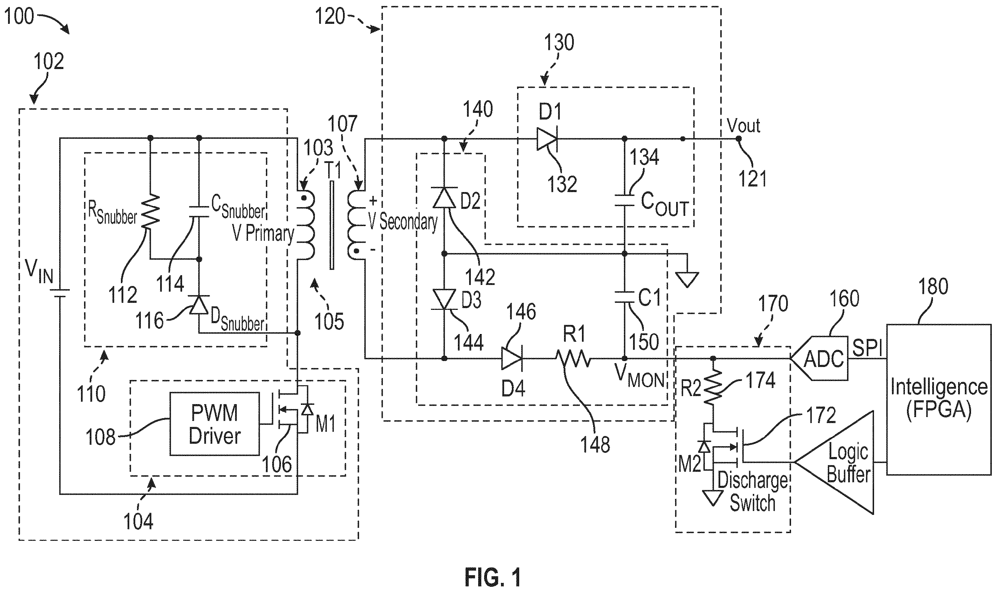

With reference now to FIG. 1, a direct current (DC) voltage monitoring circuit 100 is illustrated according to a non-limiting embodiment of the present disclosure. The DC voltage monitoring circuit 100 includes a switch mode power supply (SMPS) 102, a transformer 105, and a rectifier circuit 120.

The flyback converter 102 is configured to operate in an "ON" state to deliver an input voltage (Vin) provided by a voltage source and an "OFF" state to deactivate the input voltage (Vin). As an example, the SMPS 102 is described herein as a flyback converter 102. It should be appreciated, however, that other SMPS architectures can be used including, but not limited to, a forward converter, a push-pull converter, a half-bridge converter, and a full-bridge converter.

The flyback converter 102 includes a driver circuit 104 and a snubber circuit 110. The driver circuit 104 is configured to manage the voltage transfer from the flyback converter 102 to the rectifier circuit 120 via the transformer 105. According to a non-limiting embodiment, the driver circuit 104 includes a first switch 106 and a switch driver 108. The first switch 106 operates in an "ON" state and an "OFF" state, and the switch driver 108 continuously switches the first switch 106 between the "ON" state and "OFF" state at a switching frequency (Fsw). According to a non-limiting embodiment, the switch driver 108 can be implemented as a pulse-width modulation (PWM) switch driver 108 configured to generate a PWM signal that drives the first switch 106 at the switching frequency (Fsw)

The snubber circuit 110 is configured to absorb voltage spikes and dissipate energy to prevent excessive voltage from damaging the first switch 106 continuously switching "ON" and "OFF" at the operating at the switching frequency (Fsw). According to a non-limiting embodiment, the snubber circuit 110 includes a snubber resistor 112, a snubber capacitor 114, and a snubber diode 116. The snubber resistor 112 and the snubber capacitor 114 are connected in parallel with one another. For example, the first ends of the snubber resistor 112 and the snubber capacitor 114 are connected in common with the input voltage and a first end of the primary winding 103. The second ends of the snubber resistor 112 and the snubber capacitor 114 are connected to one another. The snubber diode 116 includes a cathode connected the second ends of the snubber resistor 112 and the snubber capacitor 114, and includes an anode connected to a second end of the primary winding 103.

In addition to protecting the first switch, the snubber circuit 110 can also provide voltage clamping functionality and noise reduction functionality. For example, the snubber capacitor 114 and the snubber diode 116 can provide clamping functionality by working together to clamp or limit the voltage spike to a safe level. In addition, the snubber capacitor 114 temporarily stores the energy of the voltage spike, while the snubber diode 116 guides the current flow during the off-switching event, helping to quickly dissipate the energy stored in the snubber capacitor 114 through the snubber resistor 112.

In terms noise reduction, the snubber circuit 110 can smooth out voltage spikes and oscillations, which reduces electromagnetic interference (EMI) and noise generated by the rapid switching of the first switch 106. The snubber circuit 110 can also improve the switching characteristics of the drive circuit 104 by shaping the voltage and current waveforms while switching the first switch 106 at the switching frequency (Fsw). In this manner, the voltage and current waveforms can be smoothened to reduce the stress on the first switch 106. This can lead to improved efficiency and longevity of the first switch 106 by reducing switching losses.

The transformer 105 includes a primary winding 103 in signal communication with the flyback converter 102 and a secondary winding 107 in signal communication with the rectifier circuit 120. The primary winding 103 has a number of windings (Np) and the secondary winding 107 has a number of windings (Ns). The number of primary windings (Np) and the number of secondary windings (Ns) can vary based on the design application of the DC voltage monitoring circuit 100.

The transformer 105 stores energy induced by a primary voltage (Vprimary) applied across the primary winding 103 by the voltage source (Vin) in response to the switch mode power supply 102 operating in the "ON" state, and releases the energy as a secondary voltage (Vsecondary) in response to the switch mode power supply 102 operating in the "OFF" state. Accordingly, the flyback converter 102 can apply the input voltage (Vin) across the primary winding 103 such that the primary voltage (Vprimary) induces the transformer 105 to store energy when the first switch 106 (M1) operates in the "ON" state. When the first switch 106 (M1) operates in the "OFF" state, the flyback converter 102 forces the transformer 105 to release the stored energy and apply the secondary voltage (Vsecondary) across the secondary winding 107 such that the secondary voltage (Vsecondary) is delivered to the rectifier circuit 120.

The rectifier circuit 120 is in signal communication with a secondary winding 107 of the transformer 105. The rectifier circuit 120 can generate a monitored voltage (Vmon) in response to the switch mode power supply 102 operating in the "ON" state, and also can rectify the secondary voltage (Vsecondary) generated by the transformer 105 in response to the switch mode power supply 102 operating in the "OFF" state.

The rectifier circuit 120 includes a half rectifier 130 and a voltage monitoring circuit 140. The half rectifier 130 is configured to rectify the secondary voltage (Vsecond) applied across the secondary winding 107 of the transformer 105. The voltage monitoring circuit 140 is configured to generate a monitored voltage (Vmon), which is indicative of the primary voltage (Vprimary) appearing across the primary winding 103 of the transformer 105, and thus the input voltage (Vin).

The half rectifier 130 includes a first diode 132 and an output capacitor 134. The first diode 132 has an anode in signal communication with a first end of the secondary winding 107 and a cathode in signal communication with a voltage output 121. The output capacitor 134 has a first terminal connected in common with the cathode of the first diode 132 and the voltage output 121 and an opposing second terminal connected to a ground reference point.

The voltage monitoring circuit 140 includes a second diode 142, a third diode 144, a fourth diode 146, a series resistor 148, and a sampling resistor 150. The second diode 142 has an anode connected to the ground reference point and a cathode connected in common with the first end of the secondary winding 107. The third diode 144 has an anode connected in common with the anode of the second diode 142 and the ground reference point, and a cathode connected to the second end of the secondary winding 107. The fourth diode 146 has an anode connected in common with the second end of the secondary winding 107. The series resistor 148 has a first end that is connected to the cathode of the fourth diode 146 and an opposing second end configured to deliver the monitored voltage to an analog-to-digital converter (ADC) 160. The sampling capacitor (C1) 150 has a first terminal connected to the ground reference point and an opposing second terminal connected to the second terminal of the series resistor 148.

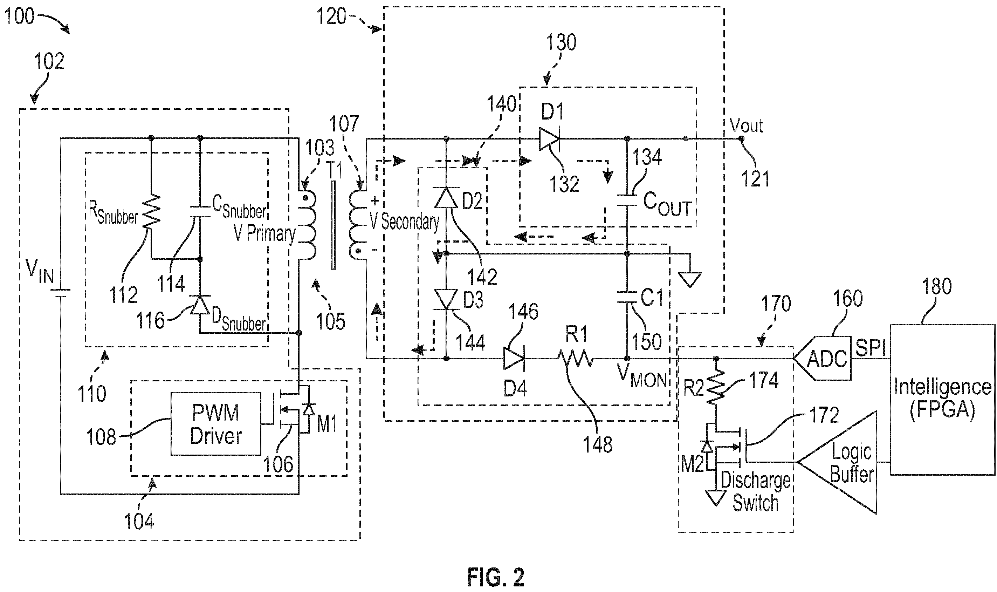

Referring to FIG. 2, the DC voltage monitoring circuit 100 is illustrated operating in the "OFF" state. When in the "OFF" state, the first switch 106 is switched off such that the energy stored in the transformer 105 is released to produce the secondary voltage (Vsecondary) having a first polarity that is applied across the secondary winding 107. The secondary voltage (Vsecondary) is rectified by the first diode 132 and the third diode 144 and charges the output capacitor 134. Accordingly, the diode 132 and the third diode 144 effectively perform a traditional flyback operation each time the first switch 106 is switched off.

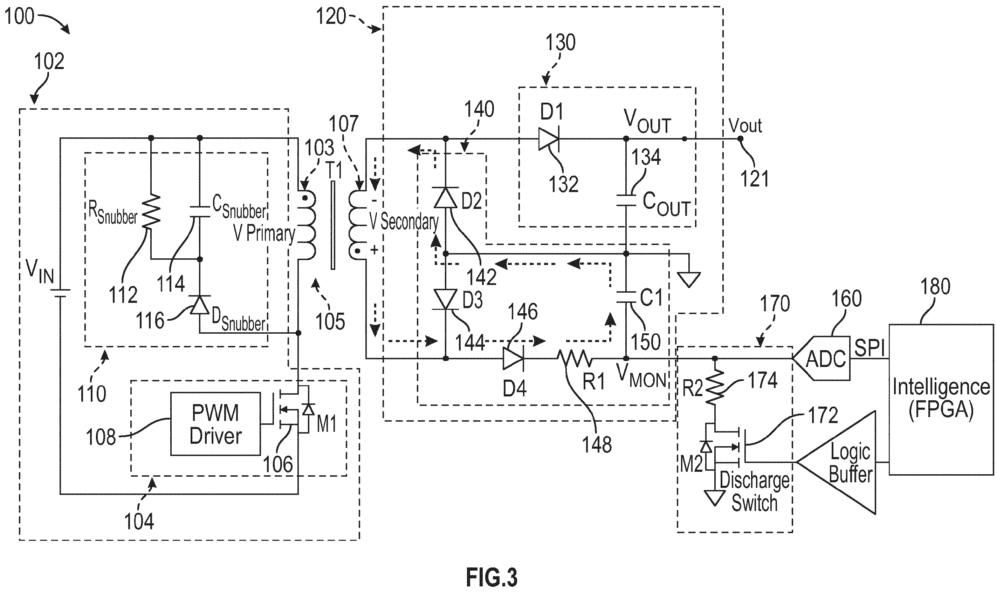

Referring to FIG. 3, the DC voltage monitoring circuit 100 is illustrated operating in the "ON" state. When in the "ON" state, the first switch 106 is switched on such that the DC-DC input voltage appears across the primary winding 103 and energy is stored in the transformer 105. During this event, a pulsed voltage amplitude is induced in the secondary winding 107. The induced voltage is rectified by the fourth diode 146 and the second diode 142, and charges the sampling capacitor 150 via the series resistor 148.

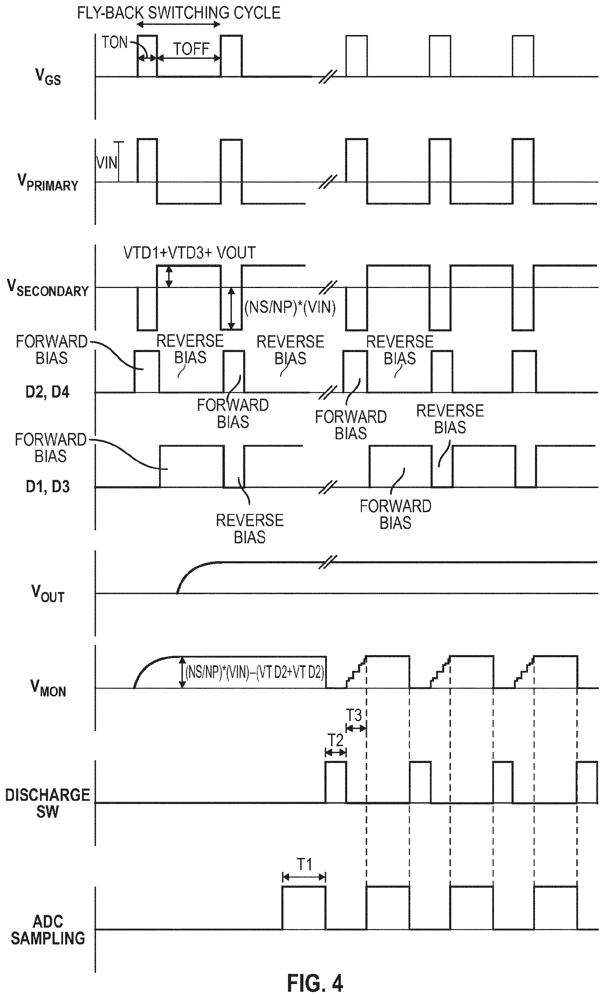

When the first switch 106 is switched "ON", current flows through the primary winding 103 generating an electric field that induces current flow through the secondary coil 107 and induces a secondary voltage (Vsecondary) having a second polarity (+-) across the secondary coil 107. When first switch 106 is switched "OFF", the energy stored in the primary winding 103 circulates through the free-wheeling diode. During this event, the voltage polarity across the primary winding 103 reverses or "flips" (-+) and current flow through the secondary winding 107 is induced to produce a voltage having a polarity (-+) across the secondary coil 107. As the PWM driver 108 continues driving the first switch 106, the voltage polarity across the secondary winding 107 flips repeatedly between positive-to-negative (+ - ) and negative-to-positive (- +). Accordingly, based on the polarity of the voltage across the secondary winding 107 at a given time, the diodes (D1 132, D2 142, D3 144 and D4 146) rectify either the output voltage (Vout) produced by the output capacitor 134 or the monitored voltage (Vmon) produced by the sampling capacitor 150 (see FIG. 4; D2,D4 and D1,D3). Accordingly, the output voltage (Vout) (i.e., the normal operating flyback voltage) can be utilized by the other components and circuits of the system, while the monitoring voltage (Vmon) can be utilized for monitoring the primary voltage/input voltage (Vprimary/Vin).

The series resistor 148 limits the current flowing through the primary winding 103 secondary winding 107 and prevents current draw from the primary winding 103. As shown in FIG. 4, for example, the amplitude of the secondary voltage (Vsecondary) appearing across the secondary winding 107 can be calculated as:

$$Vsecondary = Vin*(Ns/Np), \text{ where:} \qquad \text{Eq. 1}$$

Vin is the input voltage;

Ns is the number of turns in the secondary winding; and

Np is the number of turns in the primary winding.

The rectified voltage that appears across the series resistor 148 represents the monitored voltage (Vmon), which is indicative of the input voltage (Vin). As shown in FIG. 4, for example, the monitored voltage (Vmon) can be defined as:

$$Vmon = (Ns/Np)*(Vin- Vf(D2) - Vf(D4), \text{ where:} \qquad \text{Eq. 2}$$

Vin is the input voltage;

Ns is the number of turns in the secondary winding;

Np is the number of turns in the primary winding;

Vf(D2) is the forward voltage across diode (D2) 142; and

Vf(D4) is the forward voltage across diode (D4) 146

As described herein, the DC voltage monitoring circuit 100 can perform a sampling operation to continuously monitor the input voltage (Vin) and determine its accuracy. Referring again to FIG. 1, the DC voltage monitoring circuit 100 further includes a sampling circuit 170 configured to activate the sampling operation and deactivate the sampling operation. The sampling circuit 170 includes a discharge switch 172 and a discharge resistor 174. The discharge switch 172 operates in an "discharge ON" state and an "discharge OFF" state. When operating in the "discharge OFF" state, the discharge switch 172 activates the sampling operation to obtain a plurality of samples of the monitored voltage (Vmon). When operating in the "discharge ON" state, the discharge switch 172 deactivates the sampling operation to stop sampling the monitored voltage (Vmon). The discharge resistor 174 has a first end connected in common with the second end of the series resistor 148 and the second terminal of the sampling capacitor 150, and has an opposing second end of the discharge resistor 174 is connected to the discharge switch 172.

The discharge switch 172 can be controlled (e.g., switched on and off) using a controller 180 such as a field programmable gate array (FPGA), for example, to operate the sampling operation according to a data sampling phase, a discharge cycle phase, and a charging phase. To invoke the data sampling phase, the controller 180 switches off the discharge switch 172. Accordingly, the peak voltage across the sampling capacitor 150 is converted to a digital signal by the ADC 160 and delivered to the controller 180 so that "N" samples of the monitored voltage (Vmon) can be obtained over a duration of time T1. According to a non-limiting embodiment, the controller 180 can calculate an average of the Vmon samples, based on the Vmon average calculate the primary voltage (Vprimary) according to the equation:

$$Vprimary = Vin = (Np/Ns) *(Vmon\_average +VF(DR)+VF(D2)),$$
$$\text{Eq. 3}$$

where

Vin is the input voltage;

Ns is the number of turns in the secondary winding;

Np is the number of turns in the primary winding; and

Vfwd is a sum of the Vf(D2) and Vf(D4)

The discharge cycle phase can then be performed to dynamically monitor the DC-DC input voltage. The discharge cycle phase can be invoked by switching ON the discharge switch 172 for duration of time T2, which in turn discharges the sampling capacitor 150 and brings Vmon to zero volts (0V) or substantially 0 V, thereby effectively resetting the monitored voltage (Vmon). The time duration T2 over which the discharge switch is switched ON can be set, for example, as:

$$T2 = 5*(R2*C1), \text{ where} \qquad\qquad \text{Eq. 4}$$

R2 is the resistance of the discharge resistor; and

C1 is the capacitance of the sampling capacitor

After performing the discharge phase, the charging cycle phase can be performed to charge the discharge capacitor 150, which allows for dynamically monitoring the Vin.

Turning to FIG. 4, for example, as the induced pulses are rectified by the diodes (D2 and D4) and stored in the capacitor C1($V_{MON}$), the peak voltage is always available across the capacitors. When Vin reduces, the induced voltage also reduces, but the capacitor will contain the peak voltage corresponding to previous Vin state. To avoid this measurement error, the capacitor is discharged. The capacitor is then allowed to be subsequently recharged and settle to its max energy storage. Accordingly, sampling of the input voltage (Vin) can begin, before the capacitor again discharges to capture the present state of Vin.

Referring again to FIG. 3, the charging cycle phase can be invoked by switching OFF the discharge switch 172 for a time duration T3. Allowing more time to charge the sampling capacitor 150 increases the accuracy at which the controller 180 can determine the DC-DC input amplitude. The time duration T3 over which the discharge switch 172 is switched on can be set, for example, as:

$$T3 = N*(1/Fsw), \text{ where} \qquad\qquad \text{Eq. 5}$$

N = a value 10, 20, . . . N, and
Fsw is the switching frequency of the first switch

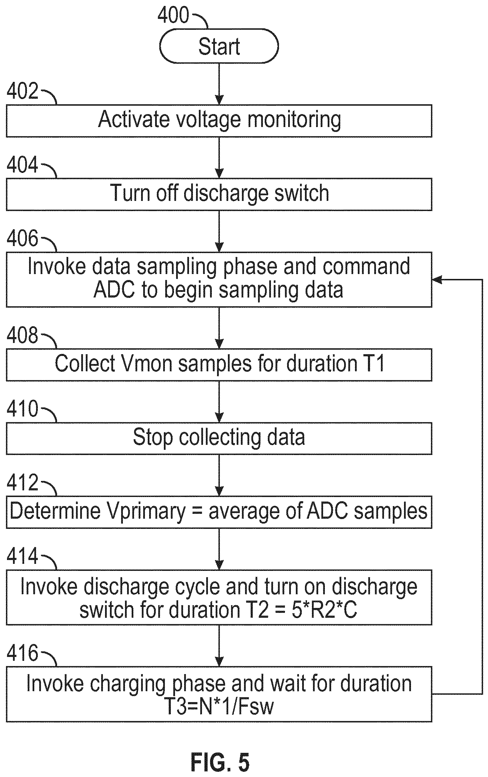

Turning now to FIG. 5, a method of performing a sampling operation to sample a supply voltage provided by the switch mode power supply is illustrated according to a non-limiting embodiment of the present disclosure. The method begins at operation 400, and the sampling operation is activated at operation 402. At operation 404, the discharge switch is turned off, and the data sampling phase is invoked at operation 406. Accordingly, the ADC is commanded to begin sampling data such that the voltage across the capacitor C1 can be measured and sampled using the ADC. At operation 408, the ADC collects Vmon samples for a time duration of T1. When T1 expires, the ADC stops collecting data at operation 410, and the sampled total number of ADC samples are averaged to determine Vprimary at operation 412.

At operation 414, the discharge cycle is invoked and the discharge switch is turned on for a time duration of T2. The discharge cycle allows for dynamically monitoring the DC-DC input voltage when the controller 180 (e.g., the FPGA) discharges the sampling capacitor 150 by switching on the discharge switch 172 for a duration of T2. As described herein, T2 can be set as $5*R_2*C_1$, which returns Vmon to 0V, effectively resetting Vmon. At operation 416, the charging phase is invoked and the controller 180 (e.g., FPGA) waits for a time duration T3. In response to invoking the charging phase, the sampling capacitor 150 charging cycle begins in steps set according to the rate of flyback switching frequency (Fsw). As described herein, T3 can be set as N*1/Fsw. In this manner, more time is allowed for the charging phase which increases the accuracy at which the controller 180 processes and calculates the DC-DC input amplitude. Accordingly, the method continues repeating operations 406 to 416 to compute (e.g., using the FPGA) the DC-DC input amplitude.

The term "about" is intended to include the degree of error associated with measurement of the particular quantity based upon the equipment available at the time of filing the application.

The terminology used herein is for the purpose of describing particular embodiments only and is not intended to be limiting of the present disclosure. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, element components, and/or groups thereof.

While the present disclosure has been described with reference to an exemplary embodiment or embodiments, it will be understood by those skilled in the art that various changes may be made and equivalents may be substituted for elements thereof without departing from the scope of the present disclosure. In addition, many modifications may be made to adapt a particular situation or material to the teachings of the present disclosure without departing from the essential scope thereof. Therefore, it is intended that the present disclosure not be limited to the particular embodiment disclosed as the best mode contemplated for carrying out this present disclosure, but that the present disclosure will include all embodiments falling within the scope of the claims.

**Claims**

1. A direct current (DC) voltage monitoring circuit comprising:

   a switch mode power supply (102) configured to provide an input voltage (Vin);
   a transformer (105) including a primary winding in signal communication with the switch mode power supply (102), the transformer (105) configured to store energy induced by a primary voltage applied across the transformer (105) by the input voltage (Vin) in response to the switch mode power supply (102) operating in the "ON" state, and to release the energy as a secondary voltage (Vsecondary) to be used as an output voltage (Vout) in response to the switch mode power supply (102) operating in the "OFF" state;
   a rectifier circuit (120) in signal communication with a secondary winding of the transformer (105), the rectifier circuit (120) configured to generate a monitored voltage (Vmon) indicative of the input voltage (Vin) in response to the switch mode power supply (102) operating in the "ON" state, and to rectify the output voltage (Vout) generated by the transformer (105) in response to the switch mode power supply (102) operating in the "OFF" state.

2. The DC voltage monitoring circuit of claim 1, wherein the switch mode power supply (102) includes a flyback converter.

3. The DC voltage monitoring circuit of claim 1 or 2, wherein the flyback converter comprises a first switch configured to continuously switch between an "ON" state and an "OFF" state at a switching frequency (Fsw).

4. The DC voltage monitoring circuit of any preceding claim, wherein the transformer (105) comprises:

   a primary winding configured to realize a primary voltage (Vprimary) based on the input voltage (Vin); and
   a secondary winding configured to deliver the secondary voltage (Vsecondary) to the rectifier circuit (120).

5. The DC voltage monitoring circuit of any preceding claim 4, wherein, the flyback converter is configured to apply the input voltage (Vin) across the primary winding to induce the transformer (105) to store energy when the first switch operates in the "ON" state and is configured to release the stored energy to apply the secondary voltage (Vsecondary) across the secondary winding when the first switch operates in the "OFF" state.

6. The DC voltage monitoring circuit of any preceding claim, wherein the rectifier circuit (120) comprises:

   a half rectifier configured to rectify the output voltage (Vout); and
   a voltage monitoring circuit configured to generate the monitored voltage (Vmon), and optionally wherein the half rectifier comprises:

   a first diode including an anode in signal communication with a first end of the secondary winding and a cathode in signal communication with a voltage output;
   an output capacitor including a first terminal connected in common with the cathode of the first diode and the voltage output, and a second terminal connected to a ground reference point.

7. The DC voltage monitoring circuit of claim 6, wherein the voltage monitoring circuit comprises:

   a second diode including an anode connected to the ground reference point and including a cathode connected in common with the first end of the secondary winding;
   a third diode including an anode connected in common with the anode of the second diode and the ground reference point, and including a cathode connected to the second end of the secondary transformer (105);
   a fourth diode including an anode connected in common with the second end of the secondary winding;
   a series resistor having a first end connected to a cathode of the fourth diode and having an opposing second end configured to deliver the monitored voltage to an analog-to-digital converter (ADC); and
   a sampling capacitor including a first terminal connected to the ground reference point and an opposing second terminal connected to the second terminal of the series resistor.

8. The DC voltage monitoring circuit of any preceding claim, further comprising a sampling circuit comprising:
a discharge switch configured to operate in a "discharge OFF" state that activates a sampling operation to sample the input voltage (Vin) and a "discharge ON" state that deactivates the sampling operation, and optionally wherein the sampling operation determines an accuracy of the input voltage (Vin).

9. The DC voltage monitoring circuit of any preceding claim, wherein the sampling operation comprises:

   a data sampling phase configured to obtain samples of the monitored voltage (Vmon);
   an analyzing phase configured to analyze the input voltage based on the samples of the monitored voltage (Vmon);
   a discharge cycle phase configured to reset the monitored voltage (Vmon); and
   a charging phase configured to charge the sampling capacitor.

10. A method of monitoring direct current (DC) voltage, the method comprising:

   providing an input voltage (Vin) from a switch mode power supply (102);
   storing energy in a transformer (105) including a primary winding in signal communication with the switch mode power supply (102), the storing of the energy induced by applying a primary voltage in response to the switch mode power supply (102) operating in the "ON" state;
   releasing the energy from the transformer (105) as a secondary voltage (Vsecondary) to be used as an output voltage (Vout)in response to the switch mode power supply (102) operating in the "OFF" state;
   generating a monitored voltage (Vmon) from a rectifier circuit (120) configured to generate a monitored voltage (Vmon) indicative of the input voltage (Vin) in response to the switch mode power supply (102) operating in the "ON" state;
   rectifying the output voltage (Vout) using the rectifier circuit (120) in response to the switch mode power supply (102) operating in the "OFF" state.

11. The method of claim 10, further comprising continuously switching a first switch included in a flyback converter between an "ON" state and an "OFF" state at a switching frequency (Fsw).

12. The method of claim 11, further comprising:

   applying the input voltage (Vin) using the flyback converter across a primary winding of the transformer (105) to induce the storage of the energy when the first switch operates in the "ON" state; and
   releasing the energy stored in the transformer (105) to apply the secondary voltage (Vsecondary) across a secondary winding of the transformer (105) when the first switch operates in the "OFF" state.

13. The method of any of claims 10 to 12, wherein the rectifier circuit (120) comprises:

   rectifying the output voltage (Vout) using a half rectifier; and
   generating the monitored voltage (Vmon) using a voltage monitoring circuit.

14. The method of any of claims 10 to 13, further comprising performing a sampling operation to sample the input voltage (Vin), the sampling operation comprising:
operating a discharge switch configured in a "discharge OFF" state that activates the sampling operation to sample the input voltage (Vin) and a "discharge ON" state that deactivates the sampling operation.

15. The method of any of claims 10 to 14, wherein the sampling operation determines an accuracy of the input voltage (Vin), or wherein the sampling operation further comprises:

   obtaining samples of the monitored voltage (Vmon) discharged from a sampling capacitor during a data sampling phase configured to obtain a samples of the monitored voltage (Vmon);
   analyzing the input voltage based on the samples of the monitored voltage (Vmon);
   resetting the monitored voltage (Vmon) during a discharge cycle phase; and
   charging the sampling capacitor during a charging phase.

FIG. 1

**FIG. 2**

FIG.3

EP 4 633 029 A1

FLY-BACK SWITCHING CYCLE

$V_{GS}$

TON TOFF

$V_{PRIMARY}$

VIN

$V_{SECONDARY}$

VTD1+VTD3+ VOUT

(NS/NP)*(VIN)

FORWARD BIAS

REVERSE BIAS    REVERSE BIAS    REVERSE BIAS

D2, D4

FORWARD BIAS    FORWARD BIAS    REVERSE BIAS

FORWARD BIAS

D1, D3

REVERSE BIAS    FORWARD BIAS

$V_{OUT}$

$V_{MON}$

(NS/NP)*(VIN)−(VT D2+VT D2)

T3

T2

DISCHARGE SW

T1

ADC SAMPLING

**FIG. 4**

400

Start

402

Activate voltage monitoring

404

Turn off discharge switch

406

Invoke data sampling phase and command ADC to begin sampling data

408

Collect Vmon samples for duration T1

410

Stop collecting data

412

Determine Vprimary = average of ADC samples

414

Invoke discharge cycle and turn on discharge switch for duration T2 = 5*R2*C

416

Invoke charging phase and wait for duration T3=N*1/Fsw

FIG. 5

| Europäisches Patentamt European Patent Office Office européen des brevets | **EUROPEAN SEARCH REPORT** | **Application Number** EP 25 16 8929 |

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 8 300 432 B2 (APPELBERG MIKAEL [SE]; ERICSSON TELEFON AB L M [SE]) 30 October 2012 (2012-10-30) * column 4 - column 5; figure 2A * ----- | 1-15 | INV. H02M3/335 G01R19/00 |

**TECHNICAL FIELDS SEARCHED (IPC)**

H02M
G01R

The present search report has been drawn up for all claims

| Place of search | Date of completion of the search | Examiner |
|---|---|---|
| The Hague | 28 July 2025 | Zeljkovic, Sandra |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 16 8929

This annex lists the patent family members relating to the patent documents cited in the above-mentioned European search report.
The members are as contained in the European Patent Office EDP file on
The European Patent Office is in no way liable for these particulars which are merely given for the purpose of information.

28-07-2025

| Patent document cited in search report | | Publication date | Patent family member(s) | | Publication date |
|---|---|---|---|---|---|
| US 8300432 | B2 | 30-10-2012 | CN | 102067427 A | 18-05-2011 |
| | | | EP | 2289159 A1 | 02-03-2011 |
| | | | US | 2011090724 A1 | 21-04-2011 |
| | | | WO | 2009154523 A1 | 23-12-2009 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- IN 202411028638